(19) Europäisches Patentamt
European Patent Office
Office européen des brevets

(11) **EP 1 245 998 A2**

(12) **DEMANDE DE BREVET EUROPEEN**

(43) Date de publication:
**02.10.2002 Bulletin 2002/40**

(51) Int Cl.⁷: **G03B 27/10**, H05K 3/00,
G03F 7/20

(21) Numéro de dépôt: **02290697.8**

(22) Date de dépôt: **20.03.2002**

(84) Etats contractants désignés:
**AT BE CH CY DE DK ES FI FR GB GR IE IT LI LU MC NL PT SE TR**
Etats d'extension désignés:
**AL LT LV MK RO SI**

(30) Priorité: **28.03.2001 FR 0104186**

(71) Demandeur: **Automa-Tech**
**27100 Val de Reuil (FR)**

(72) Inventeurs:
• **Vibet, Gilles M.**
**76140 Le Petit Quevilly (FR)**
• **Sorel, Alain M.**
**27180 Les Baux Saint Croix (FR)**

(74) Mandataire: **Dronne, Guy et al**
**Cabinet Beau de Loménie,**
**158, rue de l'Université**
**75340 Paris Cedex 07 (FR)**

(54) **Dispositif pour insoler une face d'un panneau de circuit imprimé**

(57)     L'invention concerne un dispositif pour insoler une face (118) d'un panneau (120), en particulier pour panneau de circuit imprimé. Selon un premier aspect de l'invention, le dispositif comporte :

- des moyens pour maintenir un cliché et ledit panneau (120),
- un système optique (112) émettant un faisceau lumineux (I), des moyens de traitement (116, 151) pour générer un faisceau lumineux homogène et collimaté (III) dont l'angle d'incidence moyen par rapport à la surface à insoler (118) est inférieur à 2° et dont l'homogénéité de l'éclairement présente un écart inférieur à ± 10% par rapport à la valeur moyenne, et des moyens de mise en forme (158, 160) pour transformer ledit faisceau lumineux (III) en une bande lumineuse (126, 162),
- des moyens de déplacement (121) pour générer un mouvement entre ladite bande lumineuse (126) et ladite face (118), et
- des moyens d'adaptation de la vitesse de déplacement entre ladite bande lumineuse (126) et ladite face (118).

FIG.2

## Description

La présente invention concerne un dispositif pour insoler au moins une face d'un panneau, en particulier pour panneau de circuit imprimé.

De tels dispositifs permettent de fabriquer des circuits imprimés à partir d'un panneau revêtu de matériau photosensible devant lequel on vient placer un cliché comportant les pistes à générer sur le circuit imprimé. Un faisceau lumineux balayant le cliché permet alors d'insoler l'ensemble du panneau.

On connaît de tels dispositifs d'insolation, par exemple, dans les brevets européens EP 618 505, EP 807 505 et EP 807 856, dans lesquels la source lumineuse et le panneau à insoler sont tous les deux fixes et l'insolation se fait sur toute la surface à insoler sans balayage.

Cependant, dans ce type de dispositifs où l'ensemble de la surface est exposé simultanément, la réactivité chimique du matériau photosensible n'est pas optimum. Le rendement de cette réactivité est meilleur, lorsque l'insolation est plus forte et que le temps d'exposition instantané est plus court.

On connaît de tels dispositifs dans lesquels l'insolation de la surface du panneau se fait par balayage à l'aide de la réflexion d'un faisceau lumineux provenant d'une source lumineuse sur un miroir rotatif.

Cependant, la définition du tracé des pistes, ainsi que leur finesse, sont directement liées à l'incidence du faisceau lumineux sur le cliché. En fait, chaque faisceau lumineux se trouve dans un cône de révolution ayant un axe plus ou moins incliné par rapport à la surface à insoler, appelé déclinaison. Le demi-angle au sommet du cône représente la collimation qui rend compte du parallélisme entre les rayons lumineux. On comprend donc que l'incidence d'un faisceau lumineux dépend de sa collimation et de sa déclinaison. En conséquence, lorsque la lumière n'est pas collimatée et/ou qu'un certain nombre de faisceaux lumineux arrive sur la surface à insoler avec un angle d'incidence trop important, la taille et le tracé des pistes sont généralement modifiés par rapport au cliché.

De la même manière, lorsque l'insolation ne se fait pas de manière homogène, la formation des pistes est inégale et la qualité du circuit imprimé obtenu est mauvaise.

Le but de l'invention est de fournir un dispositif d'insolation qui permet d'améliorer l'insolation d'une surface par balayage, en particulier pour la fabrication des circuits imprimés, en fournissant une bande lumineuse présentant, par rapport au panneau, à la fois une bonne incidence et une bonne homogénéité.

Un tel dispositif permet de réaliser des circuits imprimés dont la densité des pistes conductrices est très importante et impose un tracé précis et fin des pistes et donc une insolation parfaite de la surface à insoler. En fait, la taille des pistes conductrices des circuits imprimés que l'on cherche à réaliser avec un tel dispositif est comprise entre 25 µm et 50 µm et leur écartement est du même ordre de grandeur.

On comprend alors qu'en l'absence de bonne déclinaison du faisceau lumineux arrivant sur la surface à insoler, une erreur de parallaxe du faisceau lumineux entraîne un décalage de ce dernier sur la surface à insoler et donc un décalage des pistes conductrices par rapport à leur emplacement prévu. Il en va de même pour la taille des pistes qui est d'autant plus large et imprécise que la collimation du faisceau par rapport à la surface à insoler est mauvaise. L'ensemble de ces deux phénomènes peut entraîner à l'extrême, lorsque les pistes se touchent, à des courts-circuits.

En outre, la qualité du développement, c'est-à-dire de l'enlèvement de la partie du matériau photosensible qui recouvre la surface à insoler destinée à ne pas recouvrir les futures pistes lors de la gravure, et in fine la qualité de la gravure, dépend de la transformation préalable du matériau photosensible, transformation qui est liée à la quantité d'énergie lumineuse reçue. On comprend donc que lorsque le faisceau lumineux n'est pas homogène, il entraîne une transformation hétérogène de ce matériau photosensible et donc un tracé imprécis des pistes pouvant aller jusqu'à des interruptions dans ces dernières.

Pour toute la suite, on appelle bande lumineuse, l'ensemble des faisceaux lumineux qui arrivent sur la surface à insoler et l'angle d'incidence moyen correspondant à l'angle mesuré dans n'importe quel plan sensiblement transversal au plan de la surface à insoler sous lequel la moitié du flux lumineux doit arriver sur la surface, l'autre moitié pouvant arriver sous un angle quelconque.

En fait, chaque faisceau lumineux se trouve dans un cône de révolution d'axe sensiblement perpendiculaire au plan de la surface à insoler. Dans ce cas, le demi-angle au sommet qui représente la collimation, est inférieur ou égal à l'angle d'incidence moyen.

La bande lumineuse présentant une longueur au moins égale à la longueur d'un des côtés du panneau à insoler, un balayage dans une seule direction est suffisant pour insoler toute la surface du panneau. En effet, il s'agit de déplacer la bande lumineuse par rapport à la surface à insoler ou vice versa, dans la direction transversale à la longueur de la bande lumineuse pour balayer toute la surface. La direction de balayage du panneau correspond à la direction d'un des côtés du panneau. Ainsi, en générant une bande lumineuse selon une première direction parallèle à l'un des côtés du panneau, on effectue un balayage selon une seconde direction, sensiblement transversale à cette première direction.

En outre, la zone éclairée pendant l'insolation formant une bande, le temps de balayage est d'autant plus réduit que lors de l'utilisation d'un pinceau lumineux étroit et son flux est d'autant plus élevé que dans le cas d'une insolation globale. En fait, à densité lumineuse égale, plus la hauteur du quadrilatère est grande et plus le temps de balayage est court. Cependant, plus cette hauteur est grande, plus il est difficile d'obtenir une lumière de faible incidence qui est collimatée et homogène sur l'ensemble du quadrilatère et moins le flux lumineux est important. Il est donc nécessaire de trouver un compromis.

En outre, il faut pouvoir assurer une insolation identique tout au long du balayage, c'est-à-dire que l'homogénéité et l'incidence du faisceau lumineux sont constantes pendant le déplacement de la bande de lumière.

Un premier aspect de la présente invention est de fournir un dispositif qui permet d'améliorer l'insolation d'une surface, en particulier pour la fabrication des circuits imprimés, à partir d'un traitement d'un faisceau lumineux émis par une seule source lumineuse fixe.

Le but de l'invention est atteint pour ce premier aspect grâce au fait que le dispositif comporte

- des moyens pour maintenir au moins un cliché et ledit panneau sur un cadre,
- un système optique comportant une source lumineuse émettant un faisceau lumineux, des moyens de traitement dudit faisceau lumineux pour générer un faisceau lumineux homogène et collimaté dont l'angle d'incidence moyen par rapport à la surface à insoler est inférieur à 2° et dont l'homogénéité de l'éclairement présente un écart inférieur à ± 10% par rapport à la valeur moyenne, et des moyens de mise en forme permettant de transformer ledit faisceau lumineux homogène et collimaté en une bande lumineuse homogène et collimatée sur la surface du panneau à insoler comportant ledit cliché, ladite bande lumineuse homogène et collimatée étant de longueur au moins égale à la longueur d'un des côtés de ladite surface à insoler, lesdits moyens de traitement du faisceau lumineux comportant un réflecteur et un ensemble intégrateur-collimateur,
- des moyens de déplacement pour générer un mouvement relatif entre ladite bande lumineuse et ladite face à insoler dans la direction sensiblement transversale à la direction longitudinale de ladite bande lumineuse et,
- des moyens d'adaptation de la vitesse de déplacement relative entre ladite bande lumineuse et ladite face à insoler en fonction de l'éclairement de la bande lumineuse et de la sensibilité de la surface à insoler.

Dans le cas général des panneaux sensiblement rectangulaires, on comprend que le balayage est d'autant plus rapide qu'il s'effectue selon une direction parallèle à la largeur du panneau, c'est-à-dire lorsque la bande lumineuse est parallèle à la direction de la longueur du panneau. Dans ce premier cas, la longueur de la bande lumineuse est au moins égale à la longueur du côté le plus grand du panneau et le balayage se fait selon le côté le plus court.

Pour des raisons d'encombrement, on peut être amené à tourner le panneau par rapport au premier cas et à le balayer selon la direction parallèle à la longueur du panneau. Dans ce deuxième cas, la longueur de la bande lumineuse est au moins égale à la longueur du panneau et le balayage s'effectue selon la direction parallèle à la largeur du panneau.

Avantageusement, l'ensemble du système optique est fixe de sorte que les moyens optiques qu'ils comportent ne subissent pas de déréglage intempestif pouvant entraîner la dégradation du faisceau lumineux homogène et collimaté qui ressort de cet ensemble.

A l'entrée de l'ensemble intégrateur-collimateur placé après la source lumineuse, la lumière n'est ni collimatée, ni distribuée de manière homogène, alors qu'en sortie, elle est distribuée de manière homogène, par exemple avec un écart inférieur à ± 10% pour une bande lumineuse de 780×170 mm$^2$ et de manière collimatée avec un angle d'incidence moyen inférieur à 2°, préférentiellement inférieur à 1°.

L'ensemble intégrateur-collimateur comporte avantageusement une première optique de traitement destinée à distribuer la lumière de manière sensiblement homogène et une deuxième optique de traitement, ladite deuxième optique de traitement étant disposée après ladite première optique de traitement et étant destinée à collimater la lumière.

Pour des raisons de coûts et de faisabilité des moyens optiques de traitement du faisceau lumineux, chaque optique à un rôle déterminé (collimation et déclinaison ou homogénéisation).

On comprend donc que les caractéristiques des optiques de traitement et leur disposition respective sont déterminantes pour les propriétés du faisceau lumineux obtenu en sortie de l'ensemble intégrateur-collimateur.

Ainsi, avantageusement, la première optique de traitement est disposée d'une part au deuxième foyer dudit réflecteur, de sorte que ladite première optique de traitement permette de traiter ledit faisceau lumineux y entrant en un faisceau lumineux sortant homogène, et d'autre part, au foyer objet de ladite seconde optique de traitement, de sorte que cette dernière permette de traiter ledit faisceau lumineux homogène y entrant en un faisceau homogène et collimaté.

La lumière étant homogène, la variation de la puissance de l'insolation en tout point de la bande lumineuse est contrôlée et ne dépasse pas les valeurs extrémales qui risqueraient d'endommager les pistes. De même, la lumière étant collimatée, les rayons lumineux sont parallèles entre-eux et arrivent tous avec un angle d'incidence inférieur à 2°.

L'ensemble intégrateur-collimateur comporte en outre avantageusement un premier cache placé au voisinage de ladite première optique et un deuxième cache placé au voisinage de ladite deuxième optique.

Le premier cache permet d'éliminer une partie du rayonnement lumineux (non homogène, non collimaté) ayant une incidence moyenne trop éloignée de la direction moyenne de propagation à la sortie du réflecteur, tandis que le deuxième cache à la même fonction pour le faisceau lumineux homogène qui a traversé la première optique de traitement. Ces deux caches permettent de dégrossir la collimation en écartant à deux reprises les rayonnements trop divergents avant l'entrée dans la deuxième optique destinée à la collimation. Cette dernière est alors d'autant plus efficace que ces rayonnements divergents sont éliminés.

La température du cliché est un facteur déterminant dans la qualité de la réalisation du circuit imprimé, car tout gradient de température entraîne une déformation du cliché et donc du tracé des pistes. Par exemple, un simple écart de température de 2°C entraîne une distorsion de l'image.

Ainsi, pour minimiser les variations de température du cliché, le dispositif comporte avantageusement un miroir dichroïque.

L'infrarouge n'étant pas utile pour l'insolation, mais entraînant un chauffage des éléments avoisinants et en particulier du cliché, il est avantageux que le filtre anti-calorifique permette de séparer le faisceau lumineux entre l'infrarouge et l'ultraviolet et donc d'insoler le panneau avec une lumière « froide », c'est-à-dire composé essentiellement d'ultraviolet.

Avantageusement, les moyens de mise en forme comportent un premier miroir qui est divergent et convexe et un deuxième miroir qui est convergent et concave, successivement disposés à la sortie dudit ensemble intégrateur-collimateur.

A l'entrée des moyens de mise en forme, le faisceau lumineux est homogène et collimaté, par contre, il ne se présente pas encore sous forme d'une bande de lumière, mais s'étend selon deux directions généralement sous la forme d'un rectangle de taille très inférieure à celle souhaitée pour effectuer le balayage selon la longueur d'un des côtés du panneau. Le premier miroir va permettre de dé-collimater le faisceau lumineux dans le plan du miroir en le faisant diverger dans une des deux directions pour étaler le faisceau lumineux selon une bande lumineuse de longueur plus importante que sa longueur initiale.

Le deuxième miroir va quant à lui, re-collimater cette bande lumineuse dans ce même plan en la faisant converger dans cette même direction pour que la bande lumineuse ait des propriétés de collimation identiques à celles du faisceau lumineux entrant dans le système de mise en forme.

L'homogénéité du faisceau lumineux et donc de la bande lumineuse reste inchangée tout au long de la mise en forme.

La position des miroirs par rapport à l'ensemble intégrateur-collimateur n'influence pas les propriétés de la bande lumineuse, mais on comprend que leur position relative l'un par rapport à l'autre, en particulier leur écartement, ainsi que leurs caractéristiques, déterminent la géométrie de la bande lumineuse.

Ainsi, avantageusement, la longueur de ladite bande lumineuse homogène et collimatée est fonction de la distance d'écartement entre lesdits miroirs convergent et divergent, et des rayons de courbure de ces derniers et en particulier du rayon de courbure du miroir divergent. La hauteur de la bande lumineuse dépend quant à elle des caractéristiques géométriques de la lentille collimatrice et de son support. Cette hauteur de la bande lumineuse n'est que très peu affectée par les miroirs convergent et divergent.

Les moyens de déplacement comportent avantageusement un miroir de renvoi plan et mobile dans le plan défini par les axes de la face du panneau à insoler.

Ce miroir de renvoi est sans effet sur les propriétés de la bande lumineuse et est placé en sortie du système optique ayant permis le traitement et la mise en forme du faisceau lumineux. Ce miroir de renvoi est la seule partie mobile du dispositif et permet d'insoler successivement par balayage, l'intégralité de la surface en renvoyant une bande lumineuse mobile en translation vers le panneau à insoler.

Les dimensions du miroir de renvoi sont bien entendu adaptées à la longueur de la bande lumineuse souhaitée pour ne pas entraîner de diminution involontaire de cette dernière.

La géométrie de la bande lumineuse étant directement liée au système optique de mise en forme choisi, elle peut donc être facilement modifiée.

Pour obtenir une meilleure homogénéité et puissance, la source lumineuse est avantageusement disposée au premier foyer du réflecteur. Dans le cas d'une lampe à arc, c'est préférentiellement son arc qui est placé au premier foyer du réflecteur.

Ainsi, une très grande partie de la lumière émise par la source lumineuse est renvoyée vers le second foyer du réflecteur correspondant à l'entrée du système de traitement et de mise en forme qui s'effectue par la première optique de traitement en vue d'être traitée et mise en forme.

Un deuxième aspect de l'invention est de fournir un dispositif qui permet d'améliorer l'insolation d'une surface, en particulier pour la fabrication des circuits imprimés, à partir d'une source lumineuse mobile.

Le but de l'invention peut être atteint selon ce deuxième aspect de l'invention grâce au fait que le dispositif comporte :

- des moyens pour maintenir au moins un cliché et ledit panneau sur un cadre,
- un système optique comportant au moins une boîte à lumière comportant une source lumineuse et un réflecteur comportant au moins une première parabole ayant un premier foyer et une deuxième parabole ayant un deuxième foyer, lesdits premier et deuxième foyers étant situés sur l'axe correspondant à ladite direction de balayage de ladite face à insoler et en ce que la source lumineuse est placée audit premier foyer pour générer une bande lumineuse sur la surface du panneau à insoler comportant ledit cliché dont l'angle d'incidence moyen est inférieur à 15° et dont l'homogénéité de l'éclairement présente un écart inférieur à ± 10% par rapport à la valeur moyenne, ladite bande lumineuse collimatée étant de longueur au moins égale à la longueur d'un des côtés de ladite surface à insoler,

- des moyens de déplacement pour générer un mouvement relatif entre ladite bande lumineuse et ladite face à insoler dans la direction sensiblement transversale à la direction longitudinale de ladite bande lumineuse et,

- des moyens d'adaptation de la vitesse de déplacement relative entre ladite bande lumineuse et ladite face à insoler en fonction de l'éclairement de la bande lumineuse et de la sensibilité de la surface à insoler.

La forme même du réflecteur détermine les propriétés et la géométrie du faisceau lumineux.

Avantageusement, ladite première parabole se situe dans un premier plan défini par les axes comportant ladite direction de balayage et ladite deuxième parabole se situe dans un deuxième plan défini par les axes comportant ladite direction de balayage et sensiblement transversal audit premier plan.

Pour faciliter la réalisation d'un tel réflecteur et en diminuer les coûts, le réflecteur est avantageusement formé par deux parties symétriques. De plus, pour simplifier le changement de la lampe, le réflecteur comporte avantageusement une ouverture centrale.

Pour obtenir une bande lumineuse de l'ordre de $635 \times 130$ mm$^2$, le système optique comprend avantageusement cinq boîtes à lumière alignées selon la direction transversale à ladite direction de balayage, qui vont être déplacées en translation, dans la direction de balayage, soit selon la direction sensiblement transversale à la longueur de la bande lumineuse de manière à balayer tout le panneau. Dans cette configuration optique, l'incidence moyenne obtenue avec cinq lampes à arc moyen est d'environ 11°. Les lampes à arc moyen rendent la collimation du faisceau plus délicate, mais facilite la superposition des sources lumineuses.

Il est bien entendu que pour obtenir une géométrie de bande lumineuse différente, il convient d'ajuster le nombre de boîtes à lumière et leur puissance lumineuse, ainsi que la longueur de leur arc respectif et éventuellement de modifier le réflecteur.

L'écartement des boîtes est préférentiellement de 145 mm, avec des possibilités de réglage selon la direction longitudinale de la bande lumineuse pour compenser les imprécisions de réalisation des boîtes à lumières.

Selon les deux aspects précités de l'invention, la bande lumineuse collimatée forme avantageusement sur la surface à insoler, à un instant donné, un quadrilatère de hauteur comprise entre 100 mm et 150 mm et de longueur au moins égale à la longueur d'un des côtés de la surface à insoler.

Pour générer la bande lumineuse, ladite source lumineuse comprend avantageusement une lampe à décharge électrique à arc moyen ou à arc court.

Généralement, les arcs courts ont une longueur inférieure à 10 mm et les arcs moyens ont une longueur comprise entre 10 mm et 25 mm. Au-dessus de 25 mm, on parle habituellement de lampe à arc long. Plus l'arc de la lampe est court, meilleure sera la collimation ; cependant, l'alimentation des lampes est plus sophistiquée lorsque l'arc est court.

Ainsi, selon le type de lampe et le système optique choisis, la bande lumineuse présente avantageusement un angle d'incidence moyen inférieur ou égal à 2° ou 15°.

Le dispositif comporte en outre, avantageusement, des moyens de calibration pour calibrer la source lumineuse ou chacune des sources lumineuses indépendamment l'une de l'autre en présence plusieurs sources lumineuses.

En fait, en présence de plusieurs sources lumineuses, les moyens de calibration comportent avantageusement un seul capteur que l'on vient placer successivement devant chaque source lumineuse. A partir de l'intensité lumineuse relevée pour une source lumineuse, le signal du capteur va permettre de commander, par l'intermédiaire d'une boucle d'asservissement, la régulation en alimentation de la source lumineuse correspondante et donc de sa puissance émise.

Dès que la puissance de chaque source lumineuse est réglée, on obtient une puissance homogène de la bande lumineuse. Connaissant la valeur moyenne de cette puissance et la nature de la surface à insoler, un calculateur du dispositif régule le balayage de la bande lumineuse en adaptant la vitesse de déplacement de la bande lumineuse pour obtenir les conditions d'insolation souhaitées en fonction de la puissance lumineuse et de la nature de la surface à insoler.

L'invention sera bien comprise et ses avantages apparaîtront mieux à la lecture de la description détaillée qui suit, de modes de réalisation représentés à titre d'exemples non limitatifs.

La description se réfère aux dessins annexés sur lesquels :

- la figure 1 est une vue en perspective du dispositif d'insolation selon le premier aspect de l'invention,
- la figure 2 est une vue schématique du chemin parcouru par un rayon lumineux dans le dispositif de la figure 1,
- la figure 3 est une vue en perspective de l'ensemble intégrateur-collimateur,
- la figure 4 est une représentation schématique de la figure 1 vue de dessus,
- la figure 5 est une représentation schématique identique à la figure 4 en vue de côté,
- la figure 6 est une vue en perspective montrant les moyens de déplacement,

- la figure 7 est une vue d'une boîte à lumière selon le deuxième aspect de l'invention,
- la figure 8 est une coupe de la boite à lumière de la figure 7 selon VIII-VIII,
- la figure 9 est une coupe de la boite à lumière de la figure 7 selon IX-IX,
- la figure 10 est une vue en perspective d'un ensemble de cinq boites à lumière vue de derrière,
- la figure 11 est une vue en perspective de l'ensemble des cinq boites à lumière de la figure 10, vue de devant, et
- la figure 12 est une vue en perspective des moyens de calibration.

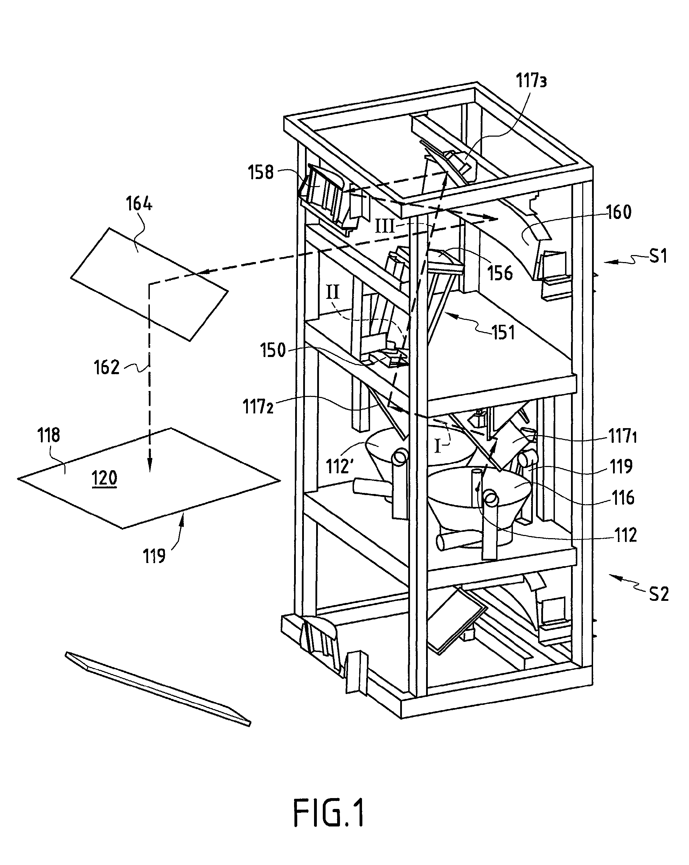

Selon un premier aspect de l'invention, le dispositif d'insolation destiné à la fabrication de circuit imprimé représenté sur les figures 1 à 6, comporte un système optique qui est composé d'une lampe à décharge et de divers éléments optiques. Dans ce cas, la lampe et un dispositif de traitement et de mise en forme du faisceau lumineux émis par la lampe, ainsi que le panneau à insoler sont fixes, et un élément optique unique, en l'espèce un miroir de renvoi, permet de réaliser le balayage de la surface du panneau à insoler.

La figure 1 est une vue d'ensemble d'un tel dispositif comportant un panneau 120 à insoler, un système optique $S_1$ permettant de traiter et mettre en forme de bande un faisceau lumineux émis par une source lumineuse 112. En l'espèce, le dispositif comporte deux systèmes optiques $S_1$ et $S_2$ permettant de traiter et mettre en forme de bande deux faisceaux lumineux émis respectivement par deux sources lumineuses 112 et 112' qui sont disposées côte à côte pour insoler le panneau sur ces deux faces. En fait, il suffit de disposer deux systèmes optiques $S_1$ et $S_2$ semblables de part et d'autre du panneau 120, au voisinage de chacune de deux faces à insoler. Les deux systèmes $S_1$ et $S_2$ sont alors commandés simultanément ou indépendamment selon le dispositif choisi.

Comme illustré sur la figure 1, lorsque les sources lumineuses 112 et 112' sont des lampes à arc, par exemple de type Xénon Mercure, il est nécessaire de les orienter vers le haut pour assurer leur fonctionnement. Ainsi, les deux lampes 112 et 112' sont orientées dans le même sens. Le système de traitement et de mise en forme $S_1$, respectivement $S_2$, est propre à chaque lampe 112, respectivement 112', et est disposé de part et d'autre des lampes 112 et 112' de manière symétrique.

Pour toute la suite de la description, on ne s'intéresse qu'à une seule lampe et un système de traitement et de mise en forme, en l'espèce au système de traitement et de mise en forme $S_1$.

Pour des questions d'encombrement, le dispositif d'insolation comporte une pluralité de miroirs de renvoi, qui ne traitent pas le faisceau lumineux, mais permettent de former des coudes dans le dispositif et en particulier dans le système de traitement et de mise en forme $S_1$.

Ces miroirs sont préférentiellement des miroirs plans de renvoi simple. Ils n'ont aucune action dans le traitement du faisceau ou dans sa mise en forme. Toutefois, il est préférable, qu'ils soient traités pour être dichroïques, par quoi ils servent de filtre anti-calorifique en séparant le faisceau lumineux entre l'infrarouge et l'ultraviolet. En effet, un tel traitement de surface permet de réfléchir environ 97% du rayonnement ultraviolet, tandis qu'il laisse passer environ 70% du rayonnement infrarouge. L'infrarouge n'étant pas utile pour l'insolation, mais entraînant le chauffage du cliché (non représenté) et des éléments avoisinants, en particulier les optiques, on comprend qu'il est avantageux de le séparer au plus tôt du faisceau lumineux et en particulier avant qu'il ne traverse le système de traitement et de mise en forme.

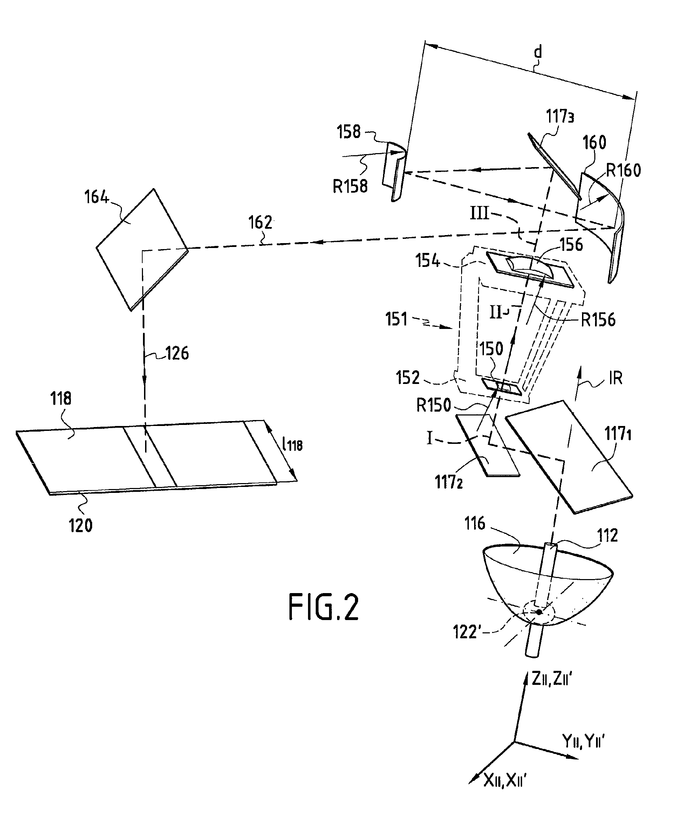

La figure 2 montre schématiquement un tel système optique qui comporte la lampe 112 à décharge à arc court, par exemple d'une puissance de 5 kW ou 8 kW, placée au premier foyer 122' d'un réflecteur 116 elliptique. On utilisera préférentiellement une lampe 112 de 5 kW, ayant un arc de $3\times3\times7$ mm$^3$.

Soit $Z_{II}Z_{II}'$ l'axe selon lequel les différents éléments optiques sont placés, correspondant à l'axe de révolution du réflecteur 116 formé par une portion d'ellipsoïde et passant par les deux foyers 122' et 124' dudit réflecteur 116. L'axe $Z_{II}Z_{II}'$ est sensiblement vertical et correspond à l'axe de propagation du faisceau lumineux sortant de la lampe 112 et du réflecteur 116. Deux axes $X_{II}X_{II}'$ et $Y_{II}Y_{II}'$ sont sensiblement perpendiculaires à l'axe $Z_{II}Z_{II}'$ de manière à définir un repère orthogonal.

Dès la sortie de la lampe 112 et du réflecteur 116, une grande partie de l'infrarouge IR est évacuée au travers d'un premier miroir de renvoi $117_1$ qui est préférentiellement refroidit par un système de refroidissement par soufflage d'air froid 119. Ce premier miroir de renvoi $117_1$ est placé à 45° au-dessus de la lampe 112 et renvoi le faisceau lumineux I vers un deuxième miroir de renvoi $117_2$ (voir figures 1 et 2).

Ce deuxième miroir de renvoi $117_2$ est orienté vers le haut préférentiellement à 45°, de manière que le faisceau lumineux I se réfléchisse vers l'entrée du système de traitement et de mise en forme, qui commence par un ensemble intégrateur-collimateur 151.

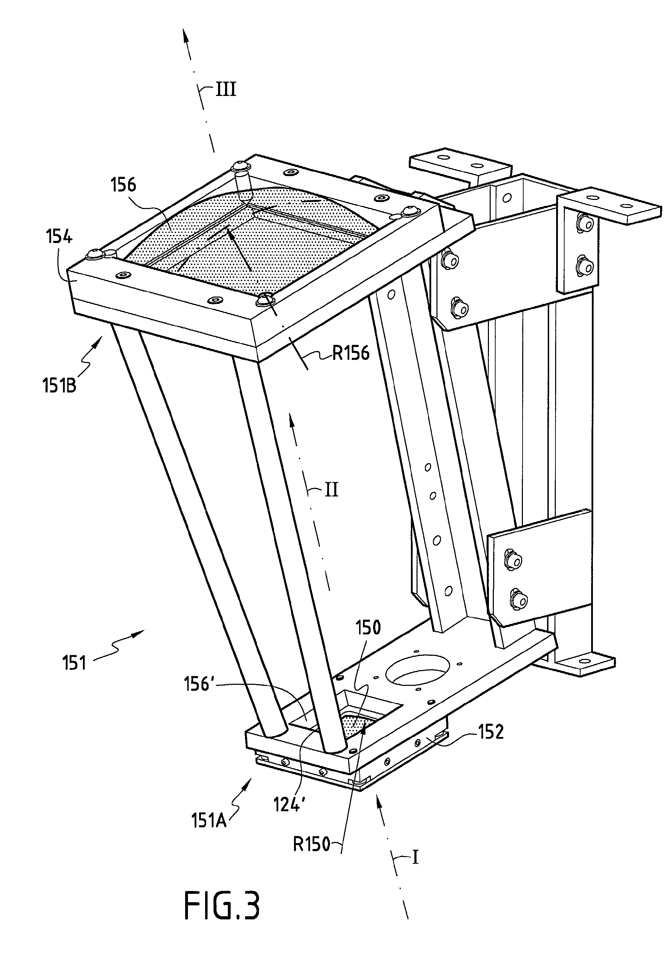

Cet ensemble intégrateur-collimateur 151, représenté en détails sur la figure 3, comporte un assemblage de différents dioptres permettant d'une part, de moyenner l'éclairement et de répartir l'intensité lumineuse pour la rendre homogène et d'autre part, de la collimater.

L'axe de l'ensemble intégrateur-collimateur 151 est confondu avec l'axe $Z_{II}Z_{II}'$ et comporte à son entrée 151A une première optique de traitement, en l'espèce une lentille intégratrice 150, et à sa sortie 151B, une deuxième optique de traitement, en l'espèce une lentille collimatrice 156. Chacune de ces lentilles 150, respectivement 156, est disposée dans un support 152, respectivement 154. Dans le système optique représenté, les deux supports 152 et 154, qui sont préférentiellement des caches, sont placés sensiblement perpendiculaire à l'axe $Z_{II}Z_{II}$', de manière à éliminer le rayonnement ayant une incidence trop éloignée de la direction moyenne de propagation à la sortie du réflecteur 116 et de sorte que l'axe optique de l'ensemble intégrateur-collimateur 151 soit confondu avec l'axe $Z_{II}Z_{II}$' pour obtenir une bonne déclinaison du faisceau sur la surface à insoler.

La lentille intégratrice 150 est une lentille cylindrique convexe, de courbure orientée vers la lentille collimatrice 156 et de rayon de courbure R150 compris entre 30 mm et 40 mm, préférentiellement sensiblement égal à 35 mm.

La lentille intégratrice 150 est placée au deuxième foyer 124' du réflecteur 116. A l'entrée de l'ensemble intégrateur-collimateur 151, les rayons lumineux I se présentent sous la forme d'un cône de révolution dont la hauteur se situe sensiblement sur l'axe $Z_{II}$-$Z_{II}$'. A l'entrée de cette lentille cylindrique 150, le faisceau lumineux I n'est pas homogène, ni collimaté, en sortie, le faisceau lumineux II est homogène avec un écart inférieur à ± 10%. Le faisceau lumineux II est en outre très légèrement collimaté par le support 152.

Ce faisceau lumineux II suit son chemin vers la lentille collimatrice 156, qui est en l'espèce une lentille sphérique de courbure orientée vers la sortie de l'ensemble intégrateur-collimateur 151 et dont le rayon de courbure $R_{156}$ est compris entre 150 mm et 200 mm, préférentiellement sensiblement égal à 170 mm.

La lentille sphérique 156 est écartée de la lentille sphérique 152 de sorte que cette dernière se trouve au foyer objet 156' de la lentille sphérique 156. A la sortie de la lentille sphérique 156, le faisceau lumineux III est collimaté avec un angle d'incidence moyen de l'ordre de 1°.

Ainsi, les deux foyers 124' et 156' sont confondus et la lentille sphérique 156A et le réflecteur 116 sont disposés de part et d'autre de la lentille cylindrique 152. En conséquence, en sortie de l'ensemble intégrateur-collimateur 151, le faisceau lumineux III est homogène avec un écart inférieur à ± 10% et collimaté.

Les foyers des lentilles 150 et 154 de l'ensemble intégrateur-collimateur 151 sont disposés sur le même axe que celui du deuxième foyer 124' de la lampe 112, c'est-à-dire le long de l'axe $Z_{II}Z'_{II}$, de sorte que le faisceau lumineux présente une déclinaison la plus faible possible lui permettant d'insoler la surface du panneau à insoler sensiblement perpendiculairement.

Ainsi, en sortie de l'ensemble intégrateur-collimateur 151 le faisceau lumineux III est homogène avec un écart inférieur à ± 10% et présente un angle d'incidence moyen de l'ordre de 1°.

En revenant aux figures 1 et 2, un troisième miroir de renvoi $117_3$ est disposé à la sortie de l'ensemble intégrateur-collimateur 151 pour former le dernier coude du chemin lumineux III.

Les moyens de mise en forme comportent des optiques de mise en forme placées immédiatement après ce troisième miroir de renvoi $117_3$, permettent successivement de dé-collimater en faisant diverger le faisceau lumineux, puis re-collimater à nouveau le flux lumineux III pour obtenir une bande lumineuse 162.

Par exemple, une première optique de mise en forme, en l'espèce un miroir divergent 158, est placée après le deuxième cache 154 supportant la lentille sphérique 156, en regard du troisième miroir de renvoi $117_3$, et une deuxième optique de mise en forme, en l'espèce un miroir convergent 160, est placée après le miroir divergent 158. Les deux miroirs 158 et 160 sont en regard, préférentiellement inclinés le plus possible vers le plan horizontal ($X_{II}X'_{II}$, $Y_{II}Y'_{II}$) pour éviter toute aberration optique. En l'espèce, les deux miroirs 158 et 160 sont écartés de moins de 45° de l'axe $Y_{II}Y'_{II}$. Le miroir divergent 158 est un miroir convexe de courbure orientée vers le miroir convergent 160 et dont le rayon de courbure $R_{158}$ est préférentiellement compris entre 150 mm et 200 mm. Le miroir convergent 160 est quant à lui un miroir concave de courbure orientée dans la même direction que celle du miroir divergent 158 et de rayon de courbure $R_{160}$, compris préférentiellement entre 1 200 mm et 1 500 mm.

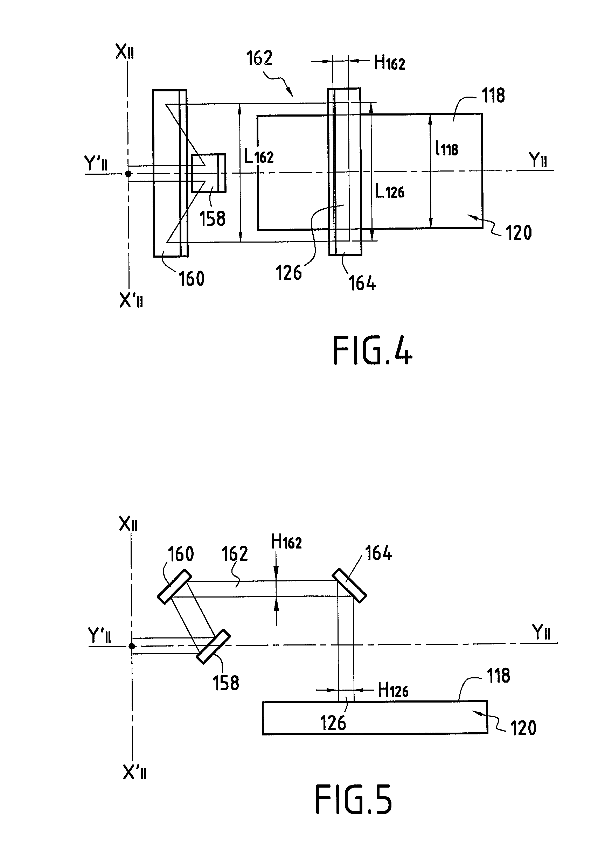

Dans cette configuration, les deux miroirs 158 et 160 permettent d'obtenir une bande lumineuse 162 (représenté sur la figure 2) de longueur $L_{162}$ (représentée sur la figure 4). La longueur $L_{162}$ est fonction du rayon de courbure $R_{158}$ du miroir divergent 158 et de l'écartement d entre les deux miroirs divergent 158 et convergent 160. La largeur ou hauteur $H_{162}$ de la bande lumineuse 162 dépend quant à elle des caractéristiques géométriques du cache 154 et en particulier de celles de la lentille sphérique 156.

Il faut ajouter que le rayon de courbure du miroir 160 peut avoir un faible effet sur la longueur $L_{162}$ de la bande lumineuse. Pour des raisons industrielles, ce rayon de courbure reste constant.

Un quatrième miroir de renvoi 164 est placé en regard du miroir convergent 160, de manière à renvoyer la bande lumineuse vers la surface 118 du panneau à insoler 120 qui est placé dans le plan horizontal ($X_{II}X'_{II}$, $Y_{II}Y'_{II}$).

Comme illustré sur la figure 4, ce quatrième miroir de renvoi 164 est destiné à renvoyer tout ou partie de cette longueur $L_{162}$. Ainsi, en fonction de la largeur du miroir 164, on obtient la longueur $L_{126}$ d'une bande lumineuse 126 qui arrive sur la surface à insoler 118 du panneau de circuit imprimé 120 maintenu dans un cadre (non représenté).

En considérant l'axe $X_{II}X_{II}$', comme l'axe horizontal correspondant à la direction de la largeur de la surface 118 du panneau à insoler 120 disposé sensiblement horizontalement défini par les axes $X_{II}X_{II}$' et $Y_{II}Y_{II}$' (représentée sur les figures 2, 4 et 5), il suffit de déplacer le miroir 164 le long de l'axe $Y_{II}Y_{II}$', c'est-à-dire selon la longueur de la surface 118 à insoler pour balayer toute la surface 118. Ainsi, ce quatrième miroir de renvoi 164 est le seul élément optique qui est mobile dans le dispositif. On comprend que la surface 118 du panneau peut être disposée différemment. Ainsi, lorsque c'est la longueur de la surface à insoler qui est placée selon l'axe $X_{II}X_{II}'$, le balayage s'effectue selon la largeur de la surface à insoler, c'est-à-dire selon l'axe $Y_{II}Y_{II}'$.

En fait, on effectue toujours le balayage transversalement à la direction longitudinale de la bande lumineuse, cette direction de balayage étant préférentiellement parallèle à la largeur ou au moins la longueur de la surface à insoler.

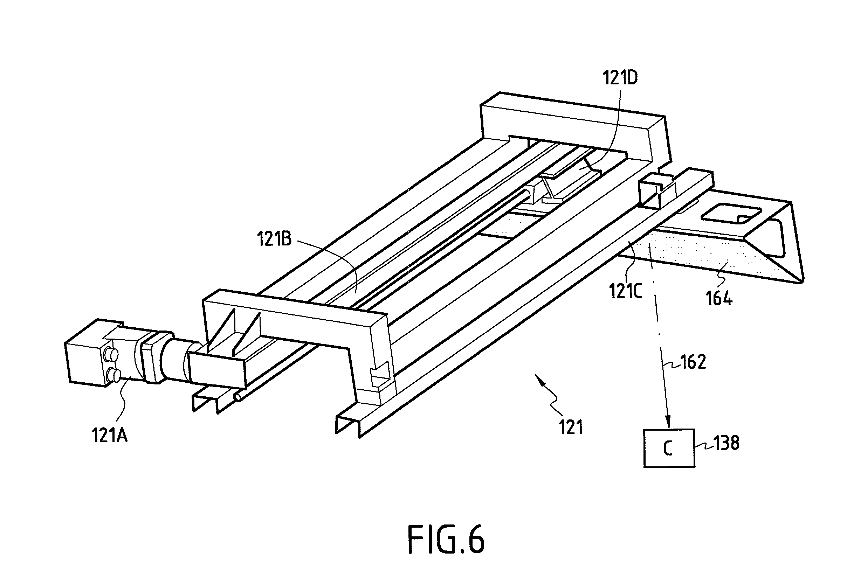

Comme illustré sur la figure 5, le quatrième miroir de renvoi 164 est à 45° par rapport à l'axe $Y_{II}Y_{II}'$, de manière à renvoyer la bande lumineuse sur la surface 118 à insoler dans le plan défini par les axes $X_{II}X_{II}'$ et $Y_{II}Y_{II}'$. Pour insoler le panneau 120 selon l'unique sens de balayage $Y_{II}Y_{II}'$, la largeur du miroir 164 sera au moins égale à la largeur $l_{118}$ de la surface 118 à insoler. Pour insoler une surface différente, il suffit de changer le miroir 164 ou de faire varier les paramètres des moyens de mise en forme.

En conséquence, selon les géométries employées pour les différentes optiques et leur configuration spatiale, on obtient une bande lumineuse 126 de hauteur $H_{126}$ et de longueur $L_{126}$ qui arrive sur la surface à insoler 118.

Le miroir 164 doit être réglé angulairement par rapport aux plans vertical et horizontal par des moyens non représentés de telle façon que durant son déplacement, il reste parallèle au panneau.

Dans la configuration du système optique décrit précédemment, on obtient préférentiellement à un instant donné sur la surface 118 à insoler, une bande lumineuse 126 de longueur $L_{126}$ comprise entre 590 mm et 1 m, préférentiellement de l'ordre de 780 mm et de hauteur $H_{126}$, comprise entre 100 mm et 200 mm, préférentiellement de l'ordre de 170 mm avec un écart d'homogénéité de l'ordre de $\pm$ 10% par rapport à la moyenne de l'éclairement qui se situe autour de 80 mW.cm$^{-2}$ et un angle d'incidence moyen inférieur ou égal à 2°, préférentiellement de l'ordre de 1°.

La vitesse de déplacement du miroir 164 conditionne la qualité et la durée d'insolation. Dans ce cas où la source lumineuse 112 est fixe et le miroir 164 est mobile, la distance entre les deux éléments augmente au cours du balayage. Il serait donc souhaitable d'adapter la vitesse de balayage, pour obtenir un éclairement présentant une qualité supérieure d'homogénéité de toute la surface à insoler tout au long de l'insolation. Toutefois, on a constaté qu'avec une vitesse de déplacement constante, on peut satisfaire aux conditions d'homogénéité énoncées précédemment.

Pour déterminer cette vitesse, un capteur photométrique 138 (représenté sur la figure 6) sensible aux rayonnements ultraviolets UV est placé dans le flux lumineux à la place du panneau à insoler et relié à l'automate du dispositif d'insolation (non représenté). La valeur de la puissance du flux mesurée est envoyée à l'automate, qui calcule la vitesse de déplacement en fonction de cette puissance lumineuse du flux et des paramètres de la surface 118 à insoler, en particulier selon la sensibilité du matériau, paramètres que l'opérateur lui aura indiqués.

Pour la calibration du dispositif, un laser est avantageusement disposé à l'emplacement du panneau à insoler émettant un faisceau lumineux visible vers une des sources lumineuses 112 ou 112' (figure 1) pour régler mécaniquement, par des moyens de déplacement non représentés, la position de chaque lampe et donc de chaque réflecteur pour s'assurer du bon positionnement de l'axe optique de chaque ensemble intégrateur-collimateur de chacun des systèmes $S_1$ et $S_2$ sur l'axe $Z_{II}Z_{II}'$. Cette calibration se fait uniquement au moment du montage du dispositif.

Par contre pour garantir une énergie constante de la bande lumineuse 126 tout au long de l'insolation, des moyens d'adaptation (non représentés) permettent d'adapter la vitesse des moyens de déplacement 121 du quatrième miroir de renvoi 164 représentés sur la figure 6. En l'espèce, ces moyens de déplacement 121 coopérant avec le dispositif (non représenté) comportent par exemple un moteur à vitesse variable 121A qui entraîne une courroie à deux poulies 121B et un support 121D mobile par rapport aux rails 121C sur lequel le miroir 164 est fixé. Tous types de moyens de déplacement connus peuvent être employés pour déplacer le miroir 164.

En fait, le dispositif étant employé à puissance électrique constante, la vitesse des moyens de déplacement est variable pour compenser la perte de puissance lumineuse due à l'écartement progressif du miroir 164 par rapport à la lampe 112.

Ainsi, par exemple, une vitesse $V_{Max}$ de départ, déterminée lorsque le miroir 164 est le plus près de la lampe 112 (au début de l'insolation), va régulièrement diminuer jusqu'à atteindre une valeur minimale $V_{MIN}$, lorsque le balayage de toute la surface 118 est terminé. Les moyens d'adaptation comportent une boucle d'asservissement programmée dans l'automate qui permet de calculer et d'adapter la vitesse du miroir 164.

Après une première utilisation, un temps d'arrêt important est indispensable (plusieurs dizaine de minutes) avant de pouvoir rallumer les lampes, en particulier pour s'assurer qu'elles ont suffisamment refroidi. Le temps d'arrêt comporte en plus le temps nécessaire de stabilisation des lampes pour que la lumière soit émise de manière homogène.

Par ailleurs, la durée de vie d'une lampe est inversement proportionnelle au nombre de fois où la lampe est allumée et éteinte. Pour pallier ces inconvénients, le dispositif comporte un volet (non représenté) qui peut être disposé au voisinage de la lentille cylindrique 152 pour masquer le rayonnement sans avoir à éteindre la lampe 112.

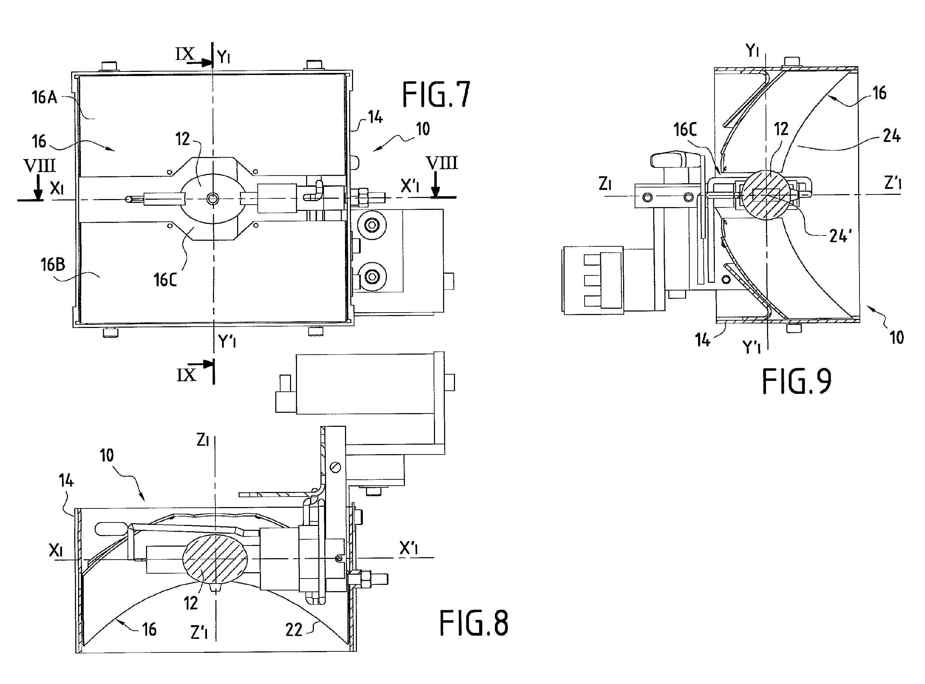

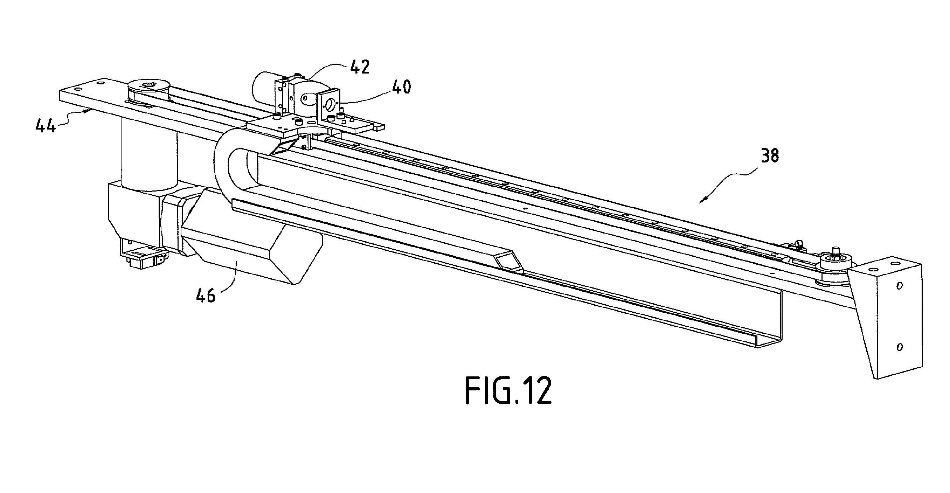

Selon le deuxième aspect de l'invention, le dispositif d'insolation destiné à la fabrication de circuit imprimé représenté sur les figures 7 à 12, comporte un système optique qui est composé d'un ensemble de boîtes à lumière comportant chacune un réflecteur de forme particulière et une lampe à décharge permet d'obtenir une bande lumineuse collimatée et homogène.

Dans ce cas, le système optique en entier, en particulier la source lumineuse, est mobile et le panneau est fixe.

La figure 7, montre une telle boîte à lumière 10 qui comporte une lampe à décharge 12 à arc moyen, préférentiellement de longueur 20 mm et de puissance 500 W. La lampe 12 est disposée dans un boîtier 14 dans lequel un réflecteur 16 a été placé.

Le fait de devoir collimater au mieux le flux impose un réflecteur de forme parabolique avec la source lumineuse placée au foyer. Cependant, ceci va à l'encontre du bon recouvrement des flux lumineux fournis par chacune des boites à lumières 10, car il faut alors un faisceau légèrement divergent. Un compromis a donc été trouvé. En fait, le réflecteur 16 ne présente pas de symétrie de révolution, mais une courbure dont la définition est donnée par l'équation suivante, dans un repère orthogonal $(X_I X_I', Y_I Y_I', Z_I Z_I')$ :

$$z = ax^2 + by^2.$$

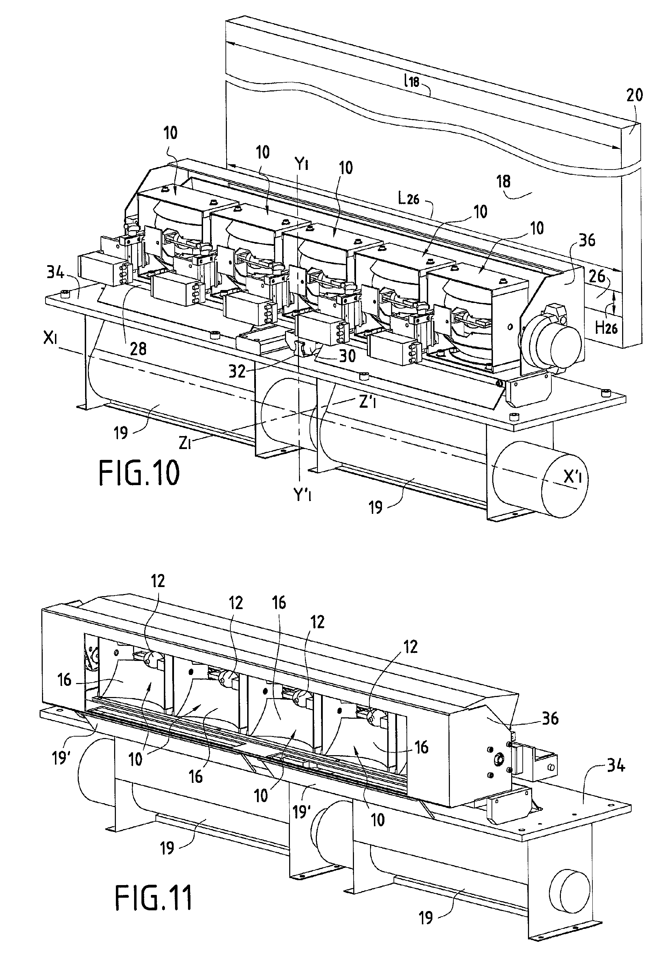

En considérant l'axe $X_I X_I'$, comme l'axe horizontal correspondant à la direction de la largeur de la surface 18 du panneau à insoler 20 disposé sensiblement verticalement (représentée sur la figure 10 sans le cliché, ni le cadre de maintien), il suffit de déplacer la boite à lumière selon l'axe $Y_I Y_I'$, sensiblement transversal à l'axe $X_I X_I'$ pour balayer toute la surface 18.

En fait, le réflecteur 16 présente une surface formée par une première parabole 24 dans le plan vertical défini par les axes $Y_I Y_I'$ et $Z_I Z_I'$ (représenté sur la figure 9) et une deuxième parabole 22 dans le plan horizontal défini par les axes $X_I X_I'$ et $Z_I Z_I'$ (représenté sur la figure 8), ayant respectivement un premier foyer 24' et un deuxième foyer (non représenté) sur l'axe $Z_I Z_I'$. La lampe 12 est placée sur le premier foyer 24'. Les rayons lumineux sont de ce fait envoyés préférentiellement selon l'axe $Z_I Z_I'$. Le bon positionnement de la lampe 12 dans un tel réflecteur 16 conditionne la collimation et la déclinaison du faisceau lumineux. En disposant une lampe à arc moyen 12 dans un réflecteur 16 dont la forme répond à l'équation précitée, on obtient un angle d'incidence inférieur à 15°.

Pour faciliter la réalisation d'un tel contour, le réflecteur 16 est réalisé en deux parties 16A et 16B symétriques par rapport au plan horizontal. De plus, pour simplifier le changement de lampe 12, le réflecteur comporte une ouverture centrale 16C qui est pratiquée dans les deux parties 16A et 16B du réflecteur 16. En fait, les deux parties 16A et 16B ne sont pas jointives, mais écartées l'une de l'autre par ladite ouverture 16C. Cette ouverture 16C présente une forme adéquate définie selon les géométries de la lampe 12.

Pour obtenir une bande lumineuse 26 ayant une géométrie sensiblement rectangulaire sur la surface 18 avec une direction longitudinale selon l'axe $X_I X_I'$, une longueur $L_{26}$ égale à la largeur $I_{18}$ de la surface 18, préférentiellement de 635 mm et une hauteur $H_{26}$ comprise entre 100 mm et 150 mm, préférentiellement de 130 mm, il est préférable de placer cinq boites à lumière 10 telles que définies précédemment.

Si on considère que le panneau 20 est disposé sensiblement à la verticale, il suffit d'aligner les cinq boites à lumière 10 selon l'axe horizontal pour former la bande lumineuse 26. Les boites à lumière 10 sont séparées les unes par rapport aux autres par une distance nominale préférentielle de 145 mm, c'est cette distance entre les boîtes à lumière qui conditionne l'homogénéité du faisceau lumineux. Un réglage de la position de chaque boite à lumière 10, permet de compenser les erreurs de réalisation de la boite à lumière 10. Préférentiellement, ce réglage peut avoir une amplitude de ± 5 mm autour de la position nominale.

Dans ces conditions, la bande lumineuse 26 présente un angle d'incidence moyen de l'ordre de 11° et un écart d'homogénéité de l'éclairement de ± 10% par rapport à la valeur moyenne qui se situe autour de 120 mW.cm$^{-2}$. En fait, la moitié du flux arrive sur la surface 18 avec un angle d'incidence inférieur à 11°.

L'ensemble des boites à lumière 10 est disposé sur un support 28 mobile en translation, dans le plan horizontal, pour permettre d'ajuster la distance entre l'ensemble des boites à lumière 10 et le panneau 20 à insoler, en fonction de la position de la surface à insoler qui dépend de la position du cadre de maintien (non représenté). Cette distance du centre de la lampe jusqu'au panneau est préférentiellement de 180 mm. Cette distance conditionne la qualité de l'homogénéité de la bande lumineuse. Le support 28 est, par exemple, disposé sur un rail comportant la partie femelle 30 d'une queue d'aronde qui coulisse sur la partie mâle 32 fixée sur un support d'entraînement 34 mobile en translation selon la direction verticale, correspondante à la direction de balayage. Les moyens de déplacement (non représentés) comportent un système d'entraînement du support d'entraînement 34.

Comme pour le dispositif décrit selon le premier aspect de l'invention, le dispositif comporte un volet 36 fixé sur le support 28 apte à pivoter devant les lampes 12. En position fermée (au cours d'un changement de panneau 20 par exemple), comme représenté sur la figure 10, le flux de la bande lumineuse 26 est interrompu, alors que les lampes 12 peuvent rester allumées. Le volet 36 est représenté en position ouverte, pendant l'insolation d'un panneau 20 (non représenté) sur la figure 11. L'utilisation d'un tel volet 36 permet ainsi d'éviter d'éteindre les lampes 12 entre chaque changement de panneaux 20 à insoler et de ce fait de réduire le temps de fabrication du circuit imprimé.

La vitesse de déplacement de ce support d'entraînement 34 détermine la qualité et la durée de l'insolation. Pour déterminer cette vitesse, l'opérateur introduit les caractéristiques de la surface à insoler, en particulier la sensibilité du matériau, dans un calculateur de l'automate du dispositif d'insolation (non représenté). La vitesse de déplacement est déterminée à chaque changement de type de surface 18 des panneaux 20 à insoler.

Pour ce faire, l'automate calcule la puissance lumineuse de la bande lumineuse 26 à partir de la puissance lumineuse de chaque lampe 12. Des moyens de calibration 38 comportant une cellule de calibration 40 et un dichroïque 42 disposés sur un support mobile 44. Les moyens de calibration sont connectés à l'automate du dispositif d'insolation (non représenté), de sorte de fournir la puissance lumineuse de la lampe 12 que l'on souhaite calibrer. A l'aide d'une boucle d'asservissement, l'automate adapte l'intensité d'alimentation de la lampe 12, jusqu'à obtenir la puissance désirée mesurée par les moyens de calibration 38.

La calibration des lampes 12 est faite lors de la mise en route du dispositif pour contrôler la stabilisation des lampes 12 et dès lors que l'on effectue un changement de lampe 12 ou bien de type de surface à insoler.

Les moyens de calibration 38 peuvent aussi servir au contrôle régulier des lampes 12 tout au long de leur utilisation. En effet, au cours du vieillissement d'une lampe, à puissance électrique d'alimentation constante, celle-ci fourni de moins en moins de puissance lumineuse. Ainsi, un asservissement de l'adaptation régulière de la puissance électrique de la lampe en fonction de la perte de puissance lumineuse mesurée, permet d'avoir une bande lumineuse 26 d'intensité sensiblement constante au cours du temps.

Les moyens de calibration 38 sont mobiles, à l'aide d'un moteur 46 par exemple, de manière à pouvoir être placés devant chaque lampe 12 de l'ensemble des boites à lumière 10.

Lorsque la puissance de chacune des lampes 12 est validée et que le cas échéant, l'opérateur a introduit les nouvelles caractéristiques de la surface à insoler, le calculateur de l'automate détermine la vitesse de balayage à adopter. Les moyens d'adaptation, non représentés, comportent l'asservissement des moyens de déplacement du support d'entraînement 34. Ces moyens d'adaptation peuvent, par exemple, comporter un moteur asservi par une boucle d'asservissement reliée à l'automate du dispositif. La boucle étant directement déterminée par l'automate, en fonction de la puissance lumineuse souhaitée et du type de surface.

Pour éviter un chauffage trop important du cliché (non représenté), on refroidit ce dernier par soufflage d'air froid au voisinage de ce dernier. En l'espèce, en se référant aux figures 10 et 11, le dispositif comporte des ventilateurs tangentiels 19 placés en dessous des boîtes à lumière 10 qui soufflent de l'air froid vers des déflecteurs 19' qui permettent de générer une bande d'air qui se propage vers la surface à insoler 18 et le cliché, en particulier vers la zone du cliché insolée par la bande de lumière 26.

## Revendications

1. Dispositif pour insoler au moins une face (118) d'un panneau (120), en particulier pour panneau de circuit imprimé, comprenant :

   - des moyens pour maintenir au moins un cliché et ledit panneau (120) sur un cadre,
   - un système optique comportant une source lumineuse (112) émettant un faisceau lumineux (I), des moyens de traitement dudit faisceau lumineux (I) pour générer un faisceau lumineux homogène et collimaté (III) dont l'angle d'incidence moyen par rapport à la surface à insoler (118) est inférieur à 2° et dont l'homogénéité de l'éclairement présente un écart inférieur à ± 10% par rapport à la valeur moyenne, et des moyens de mise en forme (158, 160) permettant de transformer ledit faisceau lumineux homogène et collimaté (III) en une bande lumineuse (126) homogène et collimatée sur la surface (118) du panneau (120) à insoler comportant ledit cliché, ladite bande lumineuse (126) homogène et collimatée étant de longueur ($L_{126}$) au moins égale à la longueur ($I_{118}$) d'un des côtés de ladite surface (118) à insoler, lesdits moyens de traitement du faisceau lumineux (I) comportant un réflecteur (116) et un ensemble intégrateur-collimateur (151),
   - des moyens de déplacement (121) pour générer un mouvement relatif entre ladite bande lumineuse (126) et ladite face (118) à insoler dans la direction ($Z_IZ_I'$; $Z_{II}Z_{II}'$) sensiblement transversale à la direction longitudinale ($X_IX_I'$; $X_{II}X_{II}'$) de ladite bande lumineuse (126) et,
   - des moyens d'adaptation de la vitesse de déplacement relative entre ladite bande lumineuse (126) et ladite face (118) à insoler en fonction de l'éclairement de la bande lumineuse (126) et de la sensibilité de la surface à insoler (118).

2. Dispositif selon la revendication précédente, **caractérisé en ce que** ledit réflecteur (116) comporte une portion d'un ellipsoïde de révolution et **en ce que** ledit ellipsoïde de révolution présente un premier foyer (122') et un deuxième foyer (124').

3. Dispositif selon l'une quelconque des revendications précédentes, **caractérisé en ce que** ledit ensemble intégrateur-collimateur (151) comporte

- une première optique de traitement (150) destinée à distribuer la lumière de manière sensiblement homogène,
- une deuxième optique de traitement (156) présentant un foyer objet (156'), ladite deuxième optique de traitement (156) étant disposée après ladite première optique de traitement (150) et étant destinée à collimater la lumière.

**4.** Dispositif selon les revendications 2 et 3, **caractérisé en ce que** ladite première optique de traitement (150) est disposée au deuxième foyer (124') dudit réflecteur (116), de sorte que ladite première optique de traitement (150) permette de traiter ledit faisceau lumineux (I) y entrant en un faisceau lumineux sortant homogène (II).

**5.** Dispositif selon la revendication précédente, **caractérisé en ce que** ladite première optique de traitement (150) est disposée au foyer objet (156') de ladite seconde optique de traitement (156), de sorte que cette dernière (156) permette de traiter ledit faisceau lumineux homogène (II) y entrant en un faisceau homogène et collimaté (III).

**6.** Dispositif selon l'une quelconque des revendications 3 à 5, **caractérisé en ce que** ladite première optique de traitement (150) est une lentille intégratrice cylindrique (150) de rayon de courbure ($R_{150}$) compris entre 30 mm et 40 mm.

**7.** Dispositif selon l'une quelconque des revendications 3 à 6, **caractérisé en ce que** ladite deuxième optique de traitement (156) est une lentille collimatrice sphérique (156) de rayon de courbure ($R_{156}$) compris entre 150 mm et 200 mm.

**8.** Dispositif selon la revendication précédente, **caractérisé en ce que** ledit ensemble intégrateur-collimateur (151) comporte en outre :

- un premier cache (152) placé au voisinage de ladite première optique (150),
- un deuxième cache (154) placé au voisinage de ladite deuxième optique (156).

**9.** Dispositif selon l'une quelconque des revendications précédentes, **caractérisé en ce que** ladite source lumineuse (112) est disposée au premier foyer (122') dudit réflecteur (116).

**10.** Dispositif selon l'une quelconque des revendications précédentes, **caractérisé en ce qu'**il comporte en outre au moins un miroir dichroïque ($117_1$, $117_2$, $117_3$).

**11.** Dispositif selon l'une quelconque des revendications précédentes, **caractérisé en ce que** lesdits moyens de mise en forme (158, 160) comportent une première optique de mise en forme (158) et une deuxième optique de mise en forme (160) qui sont successivement disposés à la sortie dudit ensemble intégrateur-collimateur (151).

**12.** Dispositif selon la revendication précédente, **caractérisé en ce que** ladite première optique de forme est un miroir divergent (158) qui est convexe et de courbure ($R_{158}$) et **en ce que** ladite deuxième optique de mise en forme est un miroir convergent (160) qui est concave et de courbure ($R_{160}$).

**13.** Dispositif selon la revendication précédente, **caractérisé en ce que** lesdits miroirs divergent (158) et convergent (160) sont écartés d'une distance d'écartement (d) et **en ce que** la longueur ($L_{126}$) de ladite bande lumineuse (126) homogène et collimatée est fonction de ladite distance d'écartement (d) et des rayons de courbure ($R_{158}$, $R_{160}$) desdits miroirs convergent (158) et divergent (160).

**14.** Dispositif selon l'une quelconque des revendications précédentes, **caractérisé en ce que** lesdits moyens de déplacement comportent un miroir de renvoi (164) plan et mobile dans le plan défini par les axes ($X_{II}X_{II}'$, $Z_{II}Z_{II}'$) de la face (118) du panneau (120) à insoler.

**15.** Dispositif pour insoler au moins une face (18) d'un panneau (20), en particulier pour panneau de circuit imprimé, comprenant :

- des moyens pour maintenir au moins un cliché et ledit panneau (20) sur un cadre,
- un système optique comportant au moins une boîte à lumière (10) comportant une source lumineuse (12) et un réflecteur (16) comportant au moins une première parabole (24) ayant un premier foyer (24') et une deuxième parabole (22) ayant un deuxième foyer, lesdits premier (22') et deuxième foyers étant situés sur l'axe ($Z_IZ_I'$; $Z_{II}Z_{II}'$) correspondant à ladite direction de balayage de ladite face (18) à insoler et en ce que la source lumineuse (12) est placée audit premier foyer (24') pour générer une bande lumineuse (26) sur la surface (18) du panneau (20) à insoler comportant ledit cliché dont l'angle d'incidence moyen est inférieur à 15° et dont l'homogénéité de l'éclairement présente un écart inférieur à ± 10% par rapport à la valeur moyenne, ladite bande lumineuse (26) collimatée étant de longueur ($L_{26}$) au moins égale à la largeur ($l_{18}$) de ladite surface (18) à insoler,
- des moyens de déplacement pour générer un mouvement relatif entre ladite bande lumineuse (26) et ladite face (18) à insoler dans la direction ($Z_IZ_I'$; $Z_{II}Z_{II}'$) de la longueur de ladite face (18) à insoler, direction qui est sensiblement transversale à la direction longitudinale ($X_IX_I$'; $X_{II}X_{II}$') de ladite bande lumineuse (26) et,

- des moyens d'adaptation de la vitesse de déplacement relative entre ladite bande lumineuse (26) et ladite face (18) à insoler en fonction de l'éclairement de la bande lumineuse (26) et de la sensibilité de la surface à insoler (18).

16. Dispositif selon la revendication précédente, **caractérisé en ce que** ladite première parabole (24) se situe dans un premier plan défini par les axes ($Y_IY_I$', $Z_IZ_I$') comportant ladite direction de balayage ($Z_IZ_I$' ; $Z_{II}Z_{II}$') et ladite deuxième parabole (22) se situe dans un deuxième plan défini par les axes ($X_IX_I$', $Z_IZ_I$') comportant ladite direction de balayage ($Z_IZ_I$'; $Z_{II}Z_{II}$') et sensiblement transversal au dit premier plan.

17. Dispositif selon l'une quelconque des revendications 15 et 16, **caractérisé en ce que** ledit réflecteur (16) comporte en outre deux parties symétriques (16A, 16B).

18. Dispositif selon l'une quelconque des revendications 15 à 17, **caractérisé en ce que** ledit réflecteur (16) comporte en outre une ouverture centrale (16C) destinée à faciliter le changement de lampe (12).

19. Dispositif selon l'une quelconque des revendications 15 à 18, **caractérisé en ce que** ledit système optique comprend cinq boîtes à lumière (10) alignées selon la direction ($X_IX_I$') sensiblement transversale à ladite direction de balayage ($Z_IZ_I$').

20. Dispositif selon la revendication précédente, **caractérisé en ce que** chacune desdites boîtes à lumière (10) est déplaçable l'une par rapport à l'autre selon la direction longitudinale de la bande lumineuse ($X_IX_I$').

21. Dispositif selon l'une quelconque des revendications précédentes, **caractérisé en ce que** ladite bande lumineuse (26 ; 126) homogène et collimatée forme un quadrilatère de hauteur ($H_{26}$; $H_{126}$) comprise entre 100 mm et 150 mm et de longueur ($L_{26}$; $L_{126}$) au moins égale à la largeur ($I_{18}$ ; $I_{118}$) de ladite surface (18 ; 118) à insoler.

22. Dispositif selon l'une quelconque des revendications précédentes, **caractérisé en ce que** ladite source lumineuse (12 ; 112) comprend une lampe à décharge électrique (12 ; 112).

23. Dispositif selon l'une quelconque des revendications 1 à 21, **caractérisé en ce que** ladite bande lumineuse (26 ; 126) présente un angle d'incidence moyen inférieur ou égal à 15°.

24. Dispositif selon l'une quelconque des revendications 1 à 21, **caractérisé en ce que** ladite bande lumineuse (26 ; 126) présente un angle d'incidence moyen inférieur ou égal à 2°.

25. Dispositif selon l'une quelconque des revendications 1 à 23, **caractérisé en ce que** ladite source lumineuse (12 ; 112) comporte une lampe à décharge électrique à arc moyen (12).

26. Dispositif selon l'une quelconque des revendications 1 à 23, **caractérisé en ce que** ladite source lumineuse (12 ; 112) comporte une lampe à décharge électrique à arc court (112).

27. Dispositif selon l'une quelconque des revendications précédentes, **caractérisé en ce qu'**il comporte en outre des moyens de calibration pour calibrer (38, 40) chaque source lumineuse (12) indépendamment l'une de l'autre.

28. Dispositif selon la revendication 26, **caractérisé en ce que** lesdits moyens de calibration (38) sont déplaçables devant chaque source lumineuse (12).

29. Dispositif selon l'une quelconque des revendications précédentes, **caractérisé en ce qu'**il comporte en outre un capteur photométrique (138) destiné à mesurer la puissance du flux lumineux.

30. Dispositif selon l'une quelconque des revendications précédentes, **caractérisé en ce que** les moyens d'adaptation permettent en outre de faire varier la vitesse de déplacement relative entre ladite bande lumineuse (26 ; 126) et ladite face (18 ; 118) à insoler au cours de l'insolation.

FIG.1

FIG.2

FIG.3

FIG.4

FIG.5

FIG.6

EP 1 245 998 A2

FIG.7

FIG.8

FIG.9

FIG.10

FIG.11

FIG.12

EP 1 245 998 A2